# EUROPEAN PATENT APPLICATION

(11) **EP 4 675 671 A1**
(43) Date of publication of application: **07.01.2026**
(21) Application number: 24857463.4
(22) Date of filing: 07.05.2024
(51) Int. Cl.: H01L 21/31

(54) **VAPORIZER**

(71) Applicant: Lintec Co., Ltd., Otsu-shi, Shiga 520-2277 (JP)
(72) Inventor: ONO, Hirofumi, Otsu-shi, Shiga 5202277 (JP); YAMAMOTO, Kenta, Otsu-shi, Shiga 5202277 (JP); YAGI, Shigeo, Otsu-shi, Shiga 5202277 (JP)
(74) Representative: HGF
(86) International application number: PCT/JP2024/016996
(87) International publication number: WO 2025/233996

(57) **Abstract**

Provided is a vaporizer capable of effectively and reliably vaporizing a liquid material for semiconductor manufacturing at a temperature as low as possible without causing heating unevenness. A vaporizer 10 includes: a liquid-material supply unit 12 that supplies a liquid material LM for semiconductor manufacturing; a vaporization unit 20 having therein a vaporization space K for vaporizing the supplied liquid material LM; and a material-gas discharge unit 40 that feeds a material gas VG obtained through vaporization to a following step. The vaporization unit 20 includes: a vaporizer body 22 that is formed of a transparent member which transmits infrared rays, and that allows infrared rays to pass through the vaporization space K from a side wall 22h on one side to the side wall 22h on another side opposite to the one side; transparent spheres 30 that are loaded in the vaporization space K and that transmit infrared rays; a heater H that is disposed so as to be spaced from the vaporizer body 22 by a gap d having a width M and that irradiates the vaporizer body 22 with infrared rays; and a reflective member 28 having a surface that faces the vaporizer body 22 with the heater H disposed therebetween, and that is a mirror surface 28k which reflects infrared rays.

## Description

### Technical Field

The present invention relates to a vaporizer capable of efficiently and reliably vaporizing a liquid material, which is used in a process of manufacturing a semiconductor, without causing heating unevenness.

### Background Art

The process of manufacturing a semiconductor includes a step in which a liquid material is required to perform a specific process, such as an oxide-film formation step and a thin-film formation step.

For example, in the oxide-film formation step, in order to form an oxide film on a surface of a silicon wafer, a material gas (specifically, oxidizing gas such as water vapor or hydrogen peroxide vapor) for forming the oxide film is supplied into a high-temperature oxidation furnace to perform an oxide-film formation process.

In the thin-film formation step, in order to form a thin film on a substrate, a liquid material is vaporized to obtain a material gas, and the material gas is supplied into a device for forming the thin film to perform a thin-film formation process.

In each of the above steps, a vaporizer is used to vaporize and supply a liquid compound. In a conventional vaporizer, for example, a vaporization surface having a large number of pores is provided in a vaporizer body, and, while this vaporization surface is heated by a heater, fine droplets obtained by ejecting a liquid material from a nozzle to form a mist are sprayed toward the vaporization surface so as to be carried by the flow of carrier gas, whereby the liquid material is vaporized. In such a vaporizer, the fine droplets are brought into contact with the gas-permeable member, and thus vaporization efficiency can be enhanced (see Patent Literatures 1 and 2).

However, conventionally, the gas-permeable member that is used to vaporize the fine droplets of the liquid material is heated through heat conduction from the heater, and thus a sufficient heating quantity does not reach a portion far from the heater and the temperature of such a portion is low, so that the heating quantity cannot be uniformly supplied over the entire gas-permeable member. Thus, in the low-temperature potion of the gas-permeable member, the droplets may be left unvaporized, which may cause clogging. If a liquid material is not vaporized to 100%, the liquid material left unvaporized forms particles and the particles are attached to a wafer surface, thereby causing serious damage in thin-film formation. Therefore, a vaporizer disclosed in Patent Literature 3 is proposed.

In the vaporizer disclosed in Patent Literature 3, a gas-permeable member for vaporizing droplets of a liquid material is formed of an opaque material such as ceramic that tends to absorb infrared rays, and an improvement is made to maintain a uniform temperature throughout the entire gas-permeable member when the droplets of the liquid material are vaporized through this opaque gas-permeable member. That is, the entire outer surface of the gas-permeable member disposed in a vaporization unit is irradiated with infrared rays from the heater through a transparent-quartz sleeve pipe.

### Citation List

### [Patent Literature]

[PTL 1] Japanese Laid-Open Patent Publication No. 2005-347598
[PTL 2] Japanese Laid-Open Patent Publication No. H10-85581
[PTL 3] Japanese Laid-Open Patent Publication No. 2009-188266

### Summary of Invention

### Technical Problem

With such a configuration, it is assumed that the entire outer surface of the gas-permeable member can be uniformly heated by the radiant heat from the heater, and the droplets flowing along the outer surface of the gas-permeable member can be equally vaporized.

Meanwhile, the infrared rays cannot pass through the opaque gas-permeable member, and the temperature is increased on the inner side of the gas-permeable member by heat transfer from the surface thereof.

In addition, when vaporized gas is discharged, the droplets flowing along the surface of the gas-permeable member are carried by the gas flow, and flow, through minute pores, from the surface to a portion on the inner-surface side of the gas-permeable member.

When the thickness of the gas-permeable member is large, the temperature of the portion on the inner-surface side is lower than that on the outer-surface side irradiated directly with the infrared rays and temperature unevenness is likely to be caused, which may cause clogging on the inner-surface side of the gas-permeable member. As a result, the thickness of the gas-permeable member is limited, and vaporization efficiency is disturbed.

In addition, in a vaporization process of a liquid material, it is important not only to prevent the temperature unevenness but also to ensure that the temperature of a liquid compound, which is a raw material, is not increased more than necessary when the liquid compound is vaporized. The reason is as follows. The liquid compound to be used in semiconductor film formation is sensitive to temperatures, and is likely to polymerize when the liquid compound reaches a high temperature. As the temperature increases, dimers are formed, and such formation is associated with formation of trimers and larger multimers, resulting in an increase in molecular weight. That is, a high molecular compound is formed. In that case, the boiling point is increased and vaporization is made difficult, finally leading to solidification. In this case, film formation is impossible. If the temperature further increases, decomposition of the compound is started, and makes thin film formation impossible. Thus, the vaporizer is required to perform vaporization at the lowest effective temperature whenever possible. Therefore, the vaporizer is required to perform vaporization at a temperature as low as possible, and moreover, with an extremely uniform temperature distribution.

The present invention has been made in view of such problems of the above conventional example, and the object of the present invention is to provide a vaporizer capable of effectively and reliably vaporizing a liquid material for semiconductor manufacturing at a temperature as low as possible, without causing heating unevenness.

### Solution to Problem

In order to attain the above-described object, a vaporizer 10 according to the present invention (claim 1) has a configuration described below.

The vaporizer 10 includes: a liquid-material supply unit 12 that supplies a liquid material LM for semiconductor manufacturing; a vaporization unit 20 having therein a vaporization space K for vaporizing the supplied liquid material LM; and a material-gas discharge unit 40 that feeds a material gas VG obtained through vaporization to a following step.

The vaporization unit 20 includes
a vaporizer body 22 that is formed of a transparent member and that allows infrared rays to pass through the vaporization space K from a side wall 22h on one side to the side wall 22h on another side opposite to the one side,
transparent spheres 30 that are loaded in the vaporization space K and that transmit infrared rays,
a heater H that is disposed so as to be spaced from the vaporizer body 22 by a gap d having a width M and that irradiates the vaporizer body 22 with infrared rays, and
a reflective member 28 having a surface that faces the vaporizer body 22 with the heater H disposed therebetween, and that is a mirror surface 28k which reflects infrared rays.

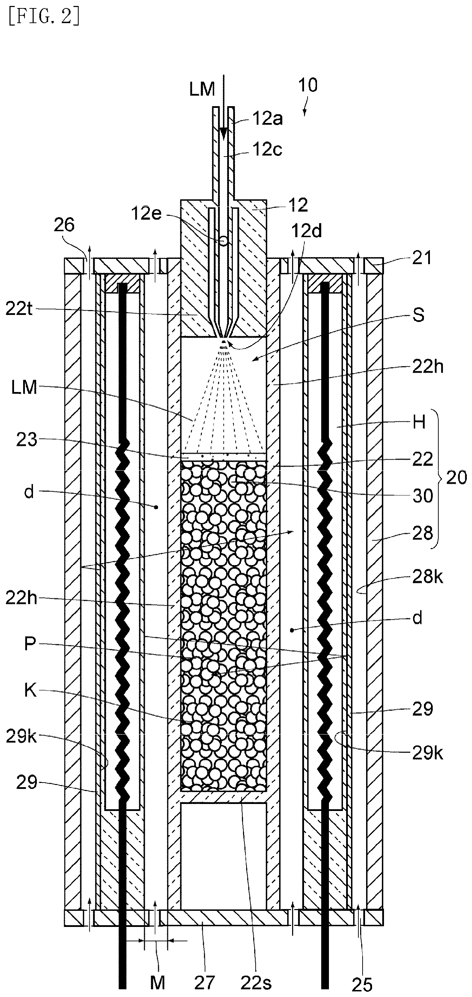

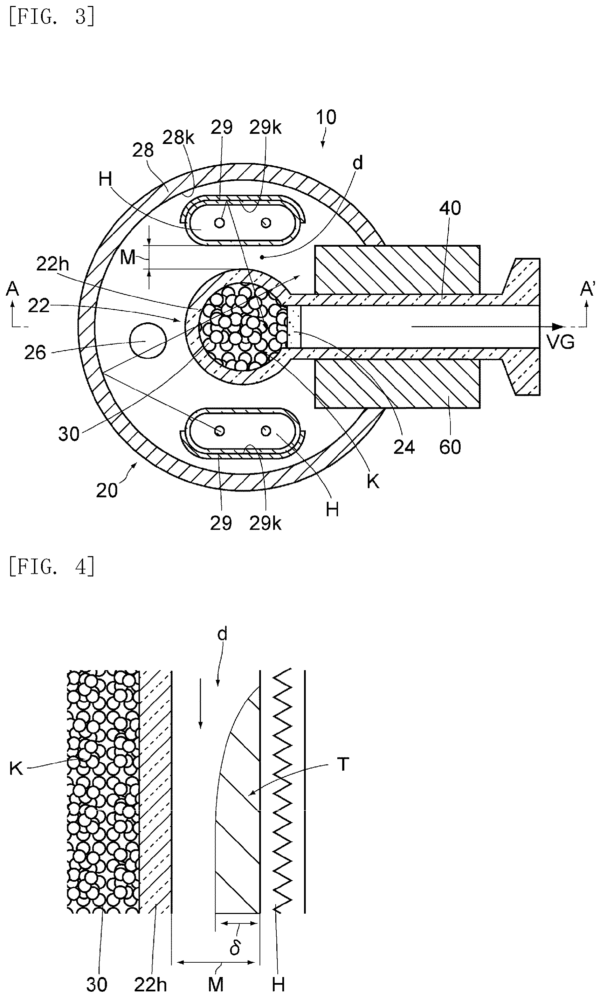

According to claim 2, in the vaporizer 10 according to claim 1, the heater H is further provided with an auxiliary reflective member 29 (FIG. 2, FIG. 3).

The auxiliary reflective member 29 is provided on a surface, on a side opposite to the vaporizer body 22, of the heater H, and has a surface that reflects infrared rays toward the vaporizer body 22 and that is a mirror surface 29k.

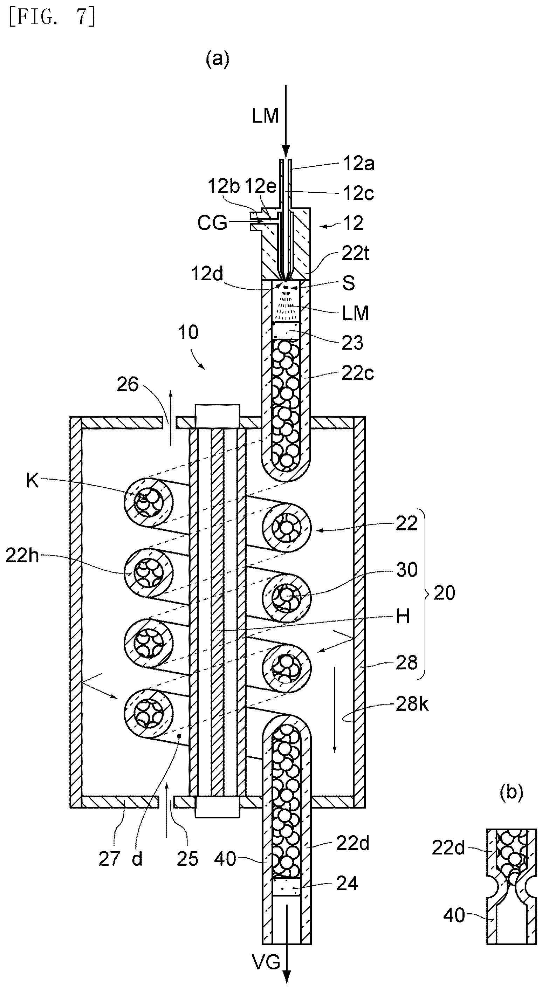

In the vaporizer 10 according to claim 1, claim 3 is a modification of the vaporizer body 22 (FIG. 7).

The vaporizer body 22 is formed of a pipe member formed in a helical shape.

In the vaporizer 10 according the claim 1, claim 4 relates to ventilation for a gap d (FIG. 2).

The vaporization unit 20 includes a replacement-gas supply portion 25 that communicates with the gap d and that allows replacement gas to be supplied, and a replacement-gas discharge portion 26 that allows the supplied replacement gas to be discharged, and the gap d between the vaporizer body 22 and the heater H serves as a flow passage for the replacement gas.

In the vaporizer 10 according to claim 1, claim 5 relates to the size of the gap d (FIG. 4).

The width M of the gap d is formed so as to be larger than a thickness δ of a temperature boundary layer T formed around the heater H.

### Advantageous Effects of Invention

According to the present invention (claim 1), the vaporizer body 22 and the spheres 30 are formed of transparent members that transmit infrared rays, and thus infrared rays emitted from the heater H uniformly and evenly pass throughout the vaporizer body 22 and the spheres 30. Since the infrared rays are repeatedly reflected off the reflective member 28 countless times, the infrared rays uniformly pass throughout the vaporizer body 22 and the spheres 30, and the entire liquid material LM flowing downward between the spheres 30 is evenly and uniformly heated to be vaporized.

The heater H is provided so as to be spaced from the vaporizer body 22 by the gap d having the width M, and thus heat conduction from the heater H to the vaporizer body 22, which may cause heating unevenness, is blocked. As a result, the entire liquid material LM supplied to the vaporization space K is uniformly heated directly by only infrared radiant heat while flowing downward between the spheres 30 loaded in the vaporization space K.

With the vaporizer body 22 being formed in a helical shape (claim 3), the length of a flow path of the liquid material LM is extended, and the liquid material LM flows downward while turning, so that the duration during which the liquid material LM is exposed to infrared rays is extended. Therefore, reliable vaporization can be achieved.

In addition, the gap d between the vaporizer body 22 and the heater H serves as a flow passage, and when replacement gas flows in the gap d (claim 4), heated gas (air) that has accumulated in the gap d and that has been heated by the heater H is discharged. As a result, the liquid material LM supplied in the vaporization space K is not affected by the heated gas (air), and is uniformly heated directly by only infrared radiant heat emitted from the heater H.

In addition, when the size (width M) of the gap d is larger than the thickness δ of the temperature boundary layer T (claim 5), heat transfer from the replacement gas flowing in the gap d that serves as the flow passage to the vaporizer body 22 is assuredly blocked.

### Brief Description of Drawings

[FIG. 1] FIG. 1 is a sectional view of a vaporizer according to a first embodiment of the present invention.
[FIG. 2] FIG. 2 is a sectional view taken along an arrowed line A-A' in FIG. 3.
[FIG. 3] FIG. 3 is a sectional view taken along an arrowed line B-B' in FIG. 1.
[FIG. 4] FIG. 4 is an enlarged view of a part around a gap in FIG. 2.
[FIG. 5] FIG. 5 is a sectional view of a vaporizer according to a second embodiment.
[FIG. 6] FIG. 6 is a sectional view taken along an arrowed line C-C' in FIG. 5.
[FIG. 7] FIG. 7(a) shows the cross section of a vaporizer according to a third embodiment, and FIG. 7(b) shows another example of a straight tube portion.
[FIG. 8] FIG. 8 conceptionally illustrates a state in which a liquid material flowing between spheres is heated by radiant heat.

### Description of Embodiments

Hereinafter, the present invention will be described with reference to the drawings. A vaporizer 10 vaporizes a liquid material LM to obtain a material gas VG and supplies the material gas VG to various semiconductor manufacturing apparatuses that use the material gas VG. The vaporizer 10 is mainly composed of a liquid-material supply unit 12, a vaporization unit 20, and a material-gas discharge unit 40.

The liquid-material supply unit 12 is a unit that supplies the liquid material LM to the vaporization unit 20, the vaporization unit 20 is a unit that vaporizes the supplied liquid material LM, and the material-gas discharge unit 40 is a unit that discharges the material gas VG obtained through vaporization to a following step. The liquid-material supply unit 12 either supplies the liquid material LM as droplets, or atomizes and supplies the liquid material LM, and the appropriate supply form is selected based on a specification required for the vaporizer 10.

A variety of liquid materials LM exist, and the appropriate liquid material LM is selected based on the type of the material gas VG to be used in each semiconductor manufacturing apparatus. The following provides a description of a hydrogen peroxide solution as a representative example.

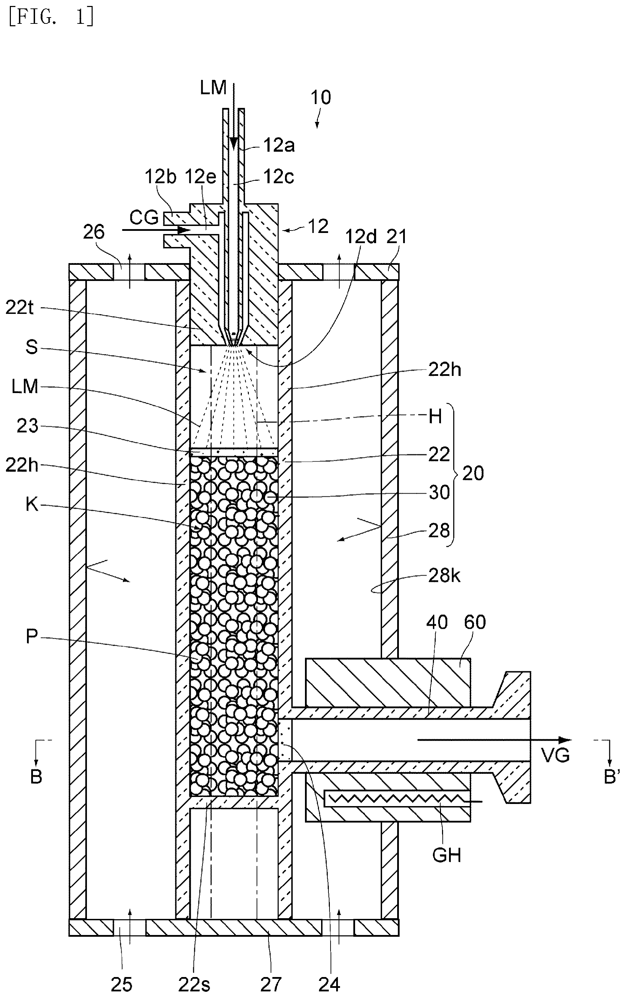

### (First embodiment: FIG. 1 to FIG. 3)

As described above, the liquid-material supply unit 12 of the vaporizer 10 according to the present invention either supplies the liquid material LM as droplets, or atomizes and supplies the liquid material LM. In the following, a case where the liquid material LM is atomized and supplied will be described, and then a case where the liquid material LM is supplied as droplets will be supplementarily described.

The liquid-material supply unit 12 includes a liquid-material introduction pipe 12a and a carrier-gas introduction pipe 12b. The liquid-material introduction pipe 12a is formed so as to protrude from the central area of an upper surface of the liquid-material supply unit 12, and a liquid-material supply hole 12c through which the liquid material LM passes is drilled at the center of the liquid-material introduction pipe 12a. A leading end of the liquid-material supply hole 12c is tapered so as to form a conical shape, and is provided with a spray port 12d that is open on the bottom of the liquid-material supply unit 12.

The carrier-gas introduction pipe 12b is provided on a side-surface side of the liquid-material introduction pipe 12a, and a carrier-gas supply path 12e that leads to the spray port 12d and that exerts a venturi effect is provided around the liquid-material introduction pipe 12a.

The vaporization unit 20 is mainly composed of a vaporizer body 22, spheres 30, a heater H, and a reflective member 28.

The vaporizer body 22 is a circular-cylindrical hollow container open on an upper surface (upper side in FIG. 1) and closed on a bottom side. The closed bottom is a bottom member 22s. An opening end on the upper-surface side is closed with the body of the liquid-material supply unit 12. The body part closing the opening end on the upper-surface side of the vaporizer body 22 is a ceiling member 22t. A space between the ceiling member 22t and the bottom member 22s of the vaporizer body 22 is a vaporization space K in which the liquid material LM is vaporized. A circular-cylindrical part of the hollow container is a side wall 22h.

As a material for the vaporizer body 22 and the liquid-material supply unit 12, a transparent member that can transmit infrared rays emitted from the heater H is selected, and transparent quartz glass is used in the present embodiment.

The spheres 30 are loaded inside the vaporizer body 22 (vaporization space K). In FIG. 1, in order to atomize the liquid material LM, the spheres 30 are loaded while a space is maintained in the upper part inside the vaporization space K so as to form an atomization space S above the spheres 30.

As a material for the spheres 30, a transparent member that can transmit infrared rays emitted from the heater H is selected as in the vaporizer body 22. In the present embodiment, spherical bodies formed of transparent quartz glass and each having a diameter of, for example, 2 to 5 mm are used.

A porous filter 23 is placed on the loaded spheres 30 as necessary. The porous filter 23 may be formed of any material as long as the material is free from being affected by the liquid material LM and allows the liquid material LM to smoothly pass through. Here, in order to ensure that such a material can transmit infrared rays emitted from the heater H and can be welded and fixed to the vaporizer body 22, a semi-molten quartz glass porous body obtained by bonding quartz glass particulate material in a semi-molten state by melting at contact areas thereof, is used.

Transparent quartz glass is used as a material for the vaporizer body 22 and the spheres 30, because the transparent quartz glass allows transmission of infrared rays emitted from the heater H until the infrared rays reach the center part of the vaporizer body 22.

Each sphere 30 has a spherical shape in the present embodiment. However, the present invention is not limited to the sphere 30 having a spherical shape, and quartz with a granular texture may be used, for example. The quartz with a granular texture has a larger surface area, which enhances the vaporization efficiency of the liquid material, and thus is preferable. However, any material that may be chipped by oscillation or other external force or that may cause particles to form is not used.

The tubular material-gas discharge unit 40 is provided at a pore drilled in a side surface of a lower end part of a hollow container forming the vaporizer body 22, and a porous filter 24 is attached to an end portion, on the vaporizer body side, inside the material-gas discharge unit 40. The porous filter 24 may be any member as long as the member is free from being affected by the material gas VG and allows the material gas VG to smoothly pass through. The same type of filter as used for the above-described porous filter 23 is also used for the porous filter 24.

A circular-cylindrical heater block 60 having therein a material-gas heater GH is attached to the outer perimeter of the tubular material-gas discharge unit 40.

A plurality of the heaters H (two heaters H in the present embodiment) are erected on both sides of the vaporizer body 22.

A gap d is provided between each heater H and the side wall 22h of the vaporizer body 22. By means of this, heat transfer from the heaters H to the vaporizer body 22 is blocked. However, since gas (air) is present in the gap d, the heat of the heaters H is transferred to the vaporizer body 22. Therefore, as described below, it is conceivable that the gap d is used as a flow passage for replacing the gas.

A reflective member 28 is a circular-cylindrical member provided to reflect infrared rays emitted from the heaters H toward the vaporization space K, and the inner surface of the reflective member 28 is finished to a mirror surface 28k by means such as plating or polishing, or aluminum foil is adhered on the inner surface of the reflective member 28a to obtain the mirror surface 28k. The reflective member 28 is provided on the outer side with respect to the heaters H so as to enclose the vaporizer body 22 as shown in FIG. 3. A ceiling plate 21 is attached to the upper end of the reflective member 28, and a bottom plate 27 is attached to the lower end thereof.

The reflective member 28, the side wall 22h of the vaporizer body 22, the ceiling plate 21, and the bottom plate 27 form a ring-shaped hollow space inside, and the heaters H are accommodated in the ring-shaped hollow space.

An auxiliary reflective member 29 is used for each heater H in FIG. 3. Since the main reflective member 28 enclosing the vaporizer body 22 is provided, the auxiliary reflective member 29 is not necessarily needed. This auxiliary reflective member 29 is provided on a surface on a back-surface side of the heater H, that is, the surface on the side opposite to the side wall 22h of the vaporizer body 22, over the entire back surface of the heater H, and has a surface that faces the vaporizer body 22 and that is the mirror surface 29k.

Next, a method for vaporizing the liquid material LM by using the vaporizer 10 will be described. The heaters H are energized such that the liquid material LM can be vaporized in the vaporization space K. When vaporization becomes possible, the liquid material LM is supplied into the liquid-material introduction pipe 12a of the liquid-material supply unit 12, and a carrier gas CG is supplied into the carrier-gas introduction pipe 12b. This causes the venturi effect to occur, and the atomized liquid material LM is uniformly sprayed from the spray port 12d into the atomization space S.

The atomized liquid material LM sprayed in the atomization space S is uniformly poured on the porous filter 23, and flows downward to the side of the spheres 30.

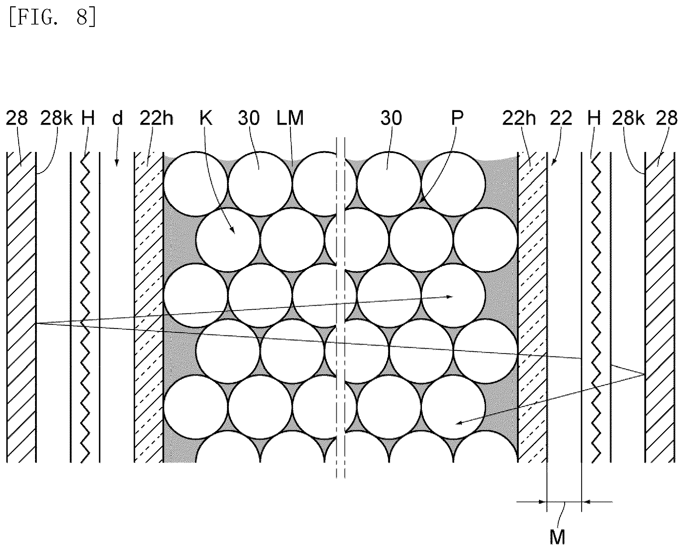

In the vaporizer body 22, the adjacent spheres 30 are in point contact and are supported with each other. Voids P each having an approximately triangular shape in a planar view are formed between the adjacent spheres 30. The surface of each void P is formed by complicated spherical concaves (FIG. 8). The liquid material LM that has flowed downward to the side of the spheres 30 flows downward while wetting the surfaces of the spheres 30, or flows downward while allowing a major part of the liquid material LM to accumulate and make liquid pools in the voids P.

On the other hand, infrared rays emitted from a heat source of each heater H are emitted in a radial direction thereof. A major part of the infrared rays emitted from the surface of the heater H, which faces the vaporizer body 22 side, proceeds toward the vaporizer body 22. The infrared rays emitted to the back-surface side of the heater H are reflected off the auxiliary reflective member 29 disposed at the back of the heater H (are reflected off the main circular-cylindrical reflective member 28, if no auxiliary reflective member 29 is provided), and proceed toward the vaporizer body 22.

Since the vaporizer body 22 is formed of transparent quartz glass that transmits infrared rays, the infrared rays proceed toward the vaporizer body 22, and pass through the side wall 22h of the vaporizer body 22 while being refracted. The spheres 30 are loaded inside the vaporizer body 22, and thus, the infrared rays that have reached the vaporization space K inside the vaporizer body 22 pass through the spheres 30 while being refracted, and reach the side wall 22h on the opposite side. Further, the infrared rays pass through the side wall 22h on the opposite side while being refracted. To avoid complicating the drawings, the infrared rays are shown by straight lines.

Most of the infrared rays that have passed through the vaporizer body 22 are reflected off the mirror surface 28k, on the opposite side, of the circular-cylindrical reflective member 28, and again passes through the vaporizer body 22. The rest of the infrared rays are reflected off the auxiliary reflective member 29. The infrared rays instantaneously and infinitely repeat the above inside the circular-cylindrical reflective member 28.

As described above, since reflection is repeated instantaneously and infinitely, the infrared rays in the vaporization space K of the vaporizer body 22 instantaneously become uniform. Thus, the temperature of the liquid material LM that has flowed in the vaporization space K and that has absorbed the uniform infrared rays becomes uniform throughout the vaporization space K. In other words, the liquid material LM is hardly heated by heat transfer from the vaporizer body 22 and the spheres 30, and is heated only by the uniform infrared rays.

Here, if the infrared rays to be used are mid infrared rays with a wavelength of 2.5 µm to 4 µm, such a wavelength includes an absorption peak wavelength (3 µm) of water which is the liquid material LM. Thus, a part of the mid infrared rays that have reached the inside of the vaporizer body 22 are absorbed in thin films formed of the liquid material LM and formed on the surfaces of the spheres 30 or are absorbed in the liquid material LM that has accumulated in the voids P, to vaporize the liquid material LM. When the thickness of each thin film of the liquid material LM is insufficient, the infrared rays pass through the thin film as they are. Since the spheres 30 are formed of transparent quartz glass that transmits infrared rays, the infrared rays that have not been absorbed in the liquid material LM pass through the spheres 30 and reach the opposite side.

The infrared rays that have not been absorbed in the liquid material LM pass through the spheres 30 loaded in the vaporizer body 22 one after another, pass through the side wall 22h on the opposite side of the vaporizer body 22, and exit to the outside. The infrared rays emitted from the vaporizer body 22 are reflected off the mirror surface 28k on the opposite side of the reflective member 28 (otherwise, is reflected off the auxiliary reflective member 29), and again proceed toward the vaporizer body 22.

The material gas VG obtained through vaporization in the vaporization space K sharply increases in volume and is discharged from the material-gas discharge unit 40 toward a following step.

In the vaporizer 10 of the present invention, the liquid material LM inside the vaporization space K can be evenly and uniformly heated only by infrared rays, and thus the vaporizer body 22 can be enlarged. Even if the vaporizer body 22 is enlarged, particles that are formed from the unvaporized liquid material LM and that may be a factor causing deterioration of the film quality of a film formed on a wafer, do not flow out. Furthermore, since uniform heating is achieved only by infrared rays as described above, the liquid material LM can be heated to and vaporized at the lowest effective temperature, and the temperature for heating is not increased more than necessary. That is, the use of the vaporizer 10 of the present invention enables stable and greatly enhanced vaporization efficiency.

In the above, the case where the liquid material LM is atomized and supplied is described. When the liquid material LM is supplied without using the carrier gas CG, the liquid material LM drops, to converge in the center area of the porous filter 23. Then, the liquid material LM flows downward as it is, and flows downward through a layer of the spheres 30 while being gradually diffused. Even in this case, infrared rays in the vaporization space K are uniform, and thus uniform vaporization is ensured as in the above description.

FIG. 1 to FIG. 3 each show an example in which heat transfer to the vaporizer body 22 in a space where the heaters H are disposed is considered.

As described above, heating by the heaters H increases the temperature of gas (air) around the heaters H. The side wall 22h of the vaporizer body 22 is heated through this heated gas (air). Thus, a width M of the gap d is elaborately designed, and the gap d is used as a flow passage for replacement gas. This can be applied to all the embodiments.

As shown in FIG. 1 to FIG. 3, a pore is provided in the ceiling plate 21 to be used as a replacement-gas supply portion 25, and a pore is provided in the bottom plate 27 to be used as a replacement-gas discharge portion 26. These pores allow the replacement gas (air) to flow in the space where the heaters H are disposed. Accordingly, the gas (air) around and heated by the heaters H rises and is discharged from the replacement-gas discharge portion 26, and outside air at room temperature flows in from the replacement-gas supply portion 25 in place of the discharged gas, so that the temperature of the space where the heaters H are disposed is maintained at the temperature of the replaced gas (air). As a result, most of the heat effect on the vaporizer body 22 due to the heaters H in the space where the heaters H are disposed is removed.

However, the distance M of the gap d matters. The outside air at room temperature that has flowed in from the replacement-gas supply portion 25 rises along the heaters H, and the temperature thereof is also gradually increased. If each heater H and the side wall 22h of the vaporizer body 22 are close to each other and the distance (width M) therebetween is smaller than a thickness δ of a temperature boundary layer T, the replacement gas flowing along the heaters H and having a temperature increased by the heaters H comes into contact with the side wall 22h of the vaporizer body 22. In this case, the temperature of the side wall 22h is affected by the heaters H.

Therefore, as shown in FIG. 4, if the distance (width M) between each heater H and the side wall 22h of the vaporizer body 22 is larger than the thickness δ of the temperature boundary layer T, replacement gas having a temperature that has not been increased flows along the side wall 22h between the side wall 22h and the temperature boundary layer T having an increased temperature, and blocks the heat effect by the temperature boundary layer T having the increased temperature. Thus, the effect by the temperature boundary layer T having the increased temperature in the space where the heaters H are disposed is assuredly removed.

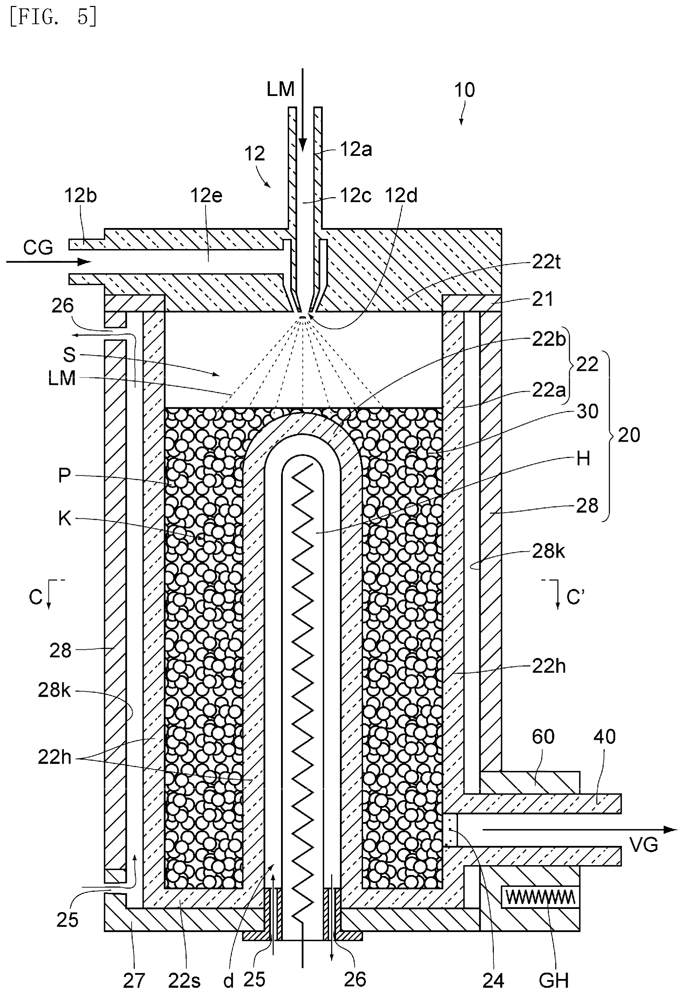

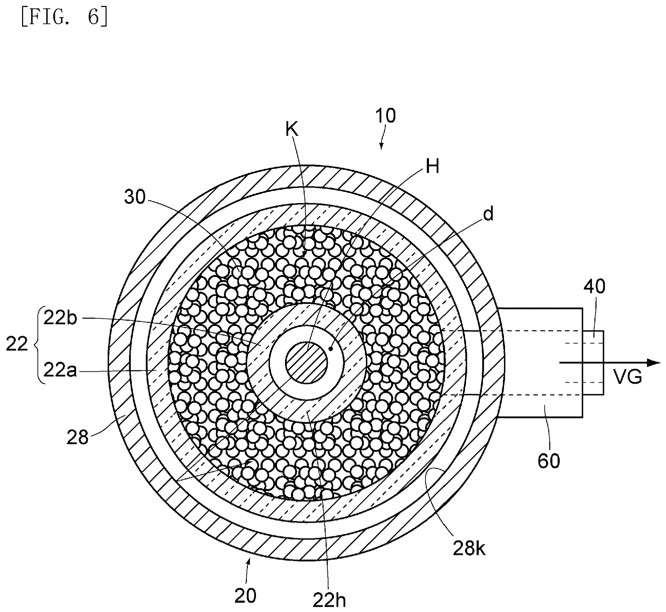

### (Second embodiment: FIG. 5, FIG. 6)

This is a case where a vaporizer body 22 is a double pipe and the heater H is provided inside an inner tube 22b of the vaporizer body 22.

The vaporizer body 22 includes a circular-cylindrical outer tube 22a, the inner tube 22b provided in the circular-cylindrical outer tube 22a and having an upper end portion formed in a hemispherical shape, and the bottom member 22s closing the bottom part therebetween. An upper-end opening of the outer tube 22a is closed with a block part (ceiling member 22t) of the liquid-material supply unit 12. An upper end portion of the inner tube 22b is disposed just below the liquid-material introduction pipe 12a. The vaporization space K is disposed between the outer tube 22a and the inner tube 22b, and is loaded with the spheres 30. The spheres 30 are loaded to a height that covers the upper end of the inner tube 22b. The porous filter 23 is provided on the spheres 30 as necessary. In FIG. 5 of this embodiment, the porous filter 23 is not shown. A space between the spheres 30 (porous filter 23) and a lower surface of the ceiling member 22t is the atomization space S.

A gap d is provided between the mirror surface 28k of the reflective member 28 and the outer tube 22a, so that the heat effect from the reflective member 28 is prevented. A gap d is also provided between the heater H and the inner tube 22b, so that the heat effect from the reflective member 28 is prevented. The gap d between the heater H and the inner tube 22b is provided with the replacement-gas supply portion 25 and the replacement-gas discharge portion 26 that communicate with the gap d, and is configured to allow replacement gas to flow therein. Further, as described above, the width of the gap d may be larger than the width M of the temperature boundary layer T so as not to receive the heat effect by the heater H. The configuration of the second embodiment is the same as that of the first embodiment, except those described above.

The heater block 60 is provided at the bottom plate 27 covering a bottom part of the reflective member 28, and the material-gas heater GH is mounted in the heater block 60.

In a vaporizer 2 of the second embodiment, the formation obtained by atomizing the liquid material LM is the same as that in the first embodiment. Although not shown, if the liquid material LM is dropped and supplied as droplets as it is without using the carrier gas CG, the formation in the second embodiment is different from that in the first embodiment.

That is, the dropped liquid material LM falls on the spheres 30 just above a hemispherical head of the inner tube 22b, to converge in this area, and then flows in the voids P between the spheres 30 directly or through the porous filter 23. Since the hemispherical head is present just below this area, the liquid material LM that has flowed downward spreads along the hemispherical head, and flows downward as it is while spreading on the periphery of the inner tube 22b. Meanwhile, the liquid material LM is uniformly heated by radiant heat to be vaporized, and is discharged from the material-gas discharge unit 40.

### (Third embodiment: FIG. 7)

This case is an example in which a vaporizer body 22 is formed of a helical transparent quartz glass pipe. The upper and lower porous filters 23, 24 are respectively placed in the upper and lower straight tube portions 22c, 22d, and the spheres 30 are loaded between the upper and lower porous filters 23, 24.

The reflective member 28 has a circular-cylindrical shape, and the ceiling plate 21 and the bottom plate 27 are respectively placed at the upper end and the lower end of the reflective member 28. The transparent quartz glass pipe serving as an outer case of the heater H is inserted in the center of the reflective member 28 between the ceiling plate 21 and the bottom plate 27, and a heat source of the heater H is placed in the up-down direction on the inner side with respect to the transparent quartz glass pipe.

A gap d is provided between the transparent quartz glass pipe of the heater H and the helical vaporizer body 22. Although not shown, replacement gas may flow in the gap, and a width M of the gap d may be larger than the thickness δ of the temperature boundary layer T.

In such a vaporizer 10, the liquid material LM supplied from the liquid-material supply unit 12 flows through the upper porous filter 23 and into a portion loaded with the spheres 30, and is vaporized while helically rotating.

With the vaporizer body 22 being formed in a helical shape, the length of a vaporization path of the liquid material LM can be extended while the height of the vaporizer 10 can be compressed, so that the vaporizer 10 can be made compact.

As shown in FIG. 7(b), the inner diameters of the straight tube portions 22c, 22d are reduced so as to be smaller than the outer diameter of each sphere 30, whereby such reduced portions may serve as the upper and lower porous filters 23, 24.

### Reference Signs List

- CG: carrier gas
- d: gap
- H: heater
- GH: material-gas heater
- K: vaporization space
- LM: liquid material
- M: width of gap
- P: void
- S: atomization space
- T: temperature boundary layer
- VG: material gas
- δ: thickness of temperature boundary layer
- 10: vaporizer
- 12: liquid-material supply unit
- 12a: liquid-material introduction pipe
- 12b: carrier-gas introduction pipe
- 12c: liquid-material supply hole
- 12e: carrier-gas supply path
- 12d: spray port
- 20: vaporization unit
- 21: ceiling plate
- 22: vaporizer body
- 22a: outer tube
- 22b: inner tube
- 22c: upper straight tube portion
- 22d: lower straight tube portion
- 22h: side wall
- 22s: bottom member
- 22t: ceiling member
- 23, 24: porous filter
- 25: replacement-gas supply portion
- 26: replacement-gas discharge portion
- 27: bottom plate
- 28: reflective member
- 28k: mirror surface
- 29: auxiliary reflective member
- 29k: mirror surface
- 30: sphere
- 40: material-gas discharge unit
- 60: heater block

## Claims

1. A vaporizer 10 comprising:
a liquid-material supply unit 12 that supplies a liquid material LM for semiconductor manufacturing;
a vaporization unit 20 having therein a vaporization space K for vaporizing the supplied liquid material LM; and
a material-gas discharge unit 40 that feeds a material gas VG obtained through vaporization to a following step, wherein
the vaporization unit 20 includes
a vaporizer body 22 that is formed of a transparent member and that allows infrared rays to pass through the vaporization space K from a side wall 22h on one side to the side wall 22h on another side opposite to the one side,
transparent spheres 30 that are loaded in the vaporization space K and that transmit infrared rays,
a heater H that is disposed so as to be spaced from the vaporizer body 22 by a gap d having a width M and that irradiates the vaporizer body 22 with infrared rays, and
a reflective member 28 having a surface that faces the vaporizer body 22 with the heater H disposed therebetween, and that is a mirror surface 28k which reflects infrared rays.

2. The vaporizer according to claim 1, wherein an auxiliary reflective member 29 is provided on a surface, on a side opposite to the vaporizer body 22, of the heater H, and has a surface that reflects infrared rays toward the vaporizer body 22 and that is a mirror surface 29k.

3. The vaporizer according to claim 1, wherein the vaporizer body 22 is formed of a pipe member formed in a helical shape.

4. The vaporizer according to claim 1, wherein
the vaporization unit 20 includes a replacement-gas supply portion 25 that communicates with the gap d and that allows replacement gas to be supplied, and a replacement-gas discharge portion 26 that allows the supplied replacement gas to be discharged, and
the gap d between the vaporizer body 22 and the heater H serves as a flow passage for the replacement gas.

5. The vaporizer according to claim 1, wherein the width M of the gap d is formed so as to be larger than a thickness δ of a temperature boundary layer T formed around the heater H.
